# EUROPEAN PATENT APPLICATION

(11) **EP 1 739 490 A1**
(43) Date of publication of application: **03.01.2007**
(21) Application number: 06115074.4
(22) Date of filing: 07.06.2006
(51) Int. Cl.: G03F 7/20, G01J 1/42

(54) **Radiation energy sensor with extended lifetime**

(30) Priority: 14.06.2005 EP 05105207
(71) Applicant: Philips Intellectual Property GmbH, 20099 Hamburg (DE); Koninklijke Philips Electronics N.V., 5621 BA Eindhoven (NL)
(72) Inventor: Jonkers, Jeroen Philips Intellectual Property & St, 52066, Aachen (DE); Vaudrevange, Dominik Philips Intellectual Property, 52066, Aachen (DE)
(74) Representative: Volmer, Georg

(57) **Abstract**

The present invention relates to a radiation energy sensor which can be used for monitoring the energy of EUV radiation and/or soft X-rays. The energy sensor comprises a detection chamber (1) having a gas inlet (5) for supply of a detection gas and a measuring unit (13, 14, 15) for measuring effects which are caused by interaction of the radiation with the detection gas in said detection chamber (1) and which are dependent on the energy of the radiation. The energy sensor also comprises a second chamber (2) having a gas inlet (6) for supply of a filtering gas. Said second chamber (2) absorbing unwanted radiation is arranged between an entrance opening (3) for the radiation and said detection chamber (1) and is connected with said detection chamber (1) via a passage (7, 9, 11) allowing the straight pass of said radiation between the entrance opening (3) and the detection chamber (1). The radiation energy sensor is insensitive to debris and allows a spectral selective measuring of the energy of to be measured radiation.

## Description

The present invention relates to a radiation energy sensor, in particular for EUV-radiation and/or soft X-rays, comprising a detection chamber having a gas inlet for supply of a detection gas and a measuring unit for measuring effects which are caused by interaction of the radiation with the detection gas in said detection chamber and which are dependent on the energy of the radiation. The present invention also relates to a method of operation of such a radiation energy sensor, in particular in an EUV irradiation unit.

EUV irradiation units can be used in the field of EUV lithography for fabricating semiconductor devices with structures having dimensions of only few nanometers. The output of known EUV-radiation sources however is not stable enough to fulfill the dose specifications of a lithography apparatus. The pulse-to-pulse standard deviation is typically only in the range of 10%, whereas the dose stability for EUV lithography should be below 0.33%. The EUV-radiation is generated by a plasma discharge which forms the radiation source of the irradiation unit. The dose stability of such an EUV-radiation source can be improved when the EUV energy of each shot is measured and is used in a feed back loop to control, for instance, the discharge energy.

EUV-radiation sources apart from the desired radiation also emit charged or uncharged particles which can deposit on optical surfaces of the illumination optics of the irradiation unit as well as on the surfaces of a sensor measuring the radiation energy. The totality of such undesired particle emissions of an EUV-radiation source is called debris. A principal problem when monitoring the radiation energy close to an EUV-radiation source is the contamination of the sensor surfaces with such debris. Known energy sensors for EUV-radiation contain elements like mirrors and filters which are damaged by the debris produced by the EUV-radiation source. Most efficient EUV-radiation sources use tin vapor for plasma generation. From such plasma roughly 10¹⁵ atoms/sr/pulse in the form of fast ions, slow atoms/ions and tiny droplets are emitted in all directions. Assuming a 1 m distance between the source an the sensor, a 10 nm thick layer of tin will be deposited on the first element of the sensor in less than 10⁶ pulses, i.e. in only a couple of minutes, if no mitigation is applied. The transmission of 10 nm of tin is only 50% for EUV-radiation.

In order to avoid a fast deterioration of sensor and further optical components of the EUV irradiation unit debris mitigation systems are used to reduce the amount of debris reaching such components. The known debris mitigation systems are however not perfect, i.e. they will not remove all the debris emitted from the EUV-radiation source. There is therefore a strong need for EUV-radiation energy sensors which are insensitive to debris and can be used in an EUV-radiation source for monitoring the energy of EUV-radiation.

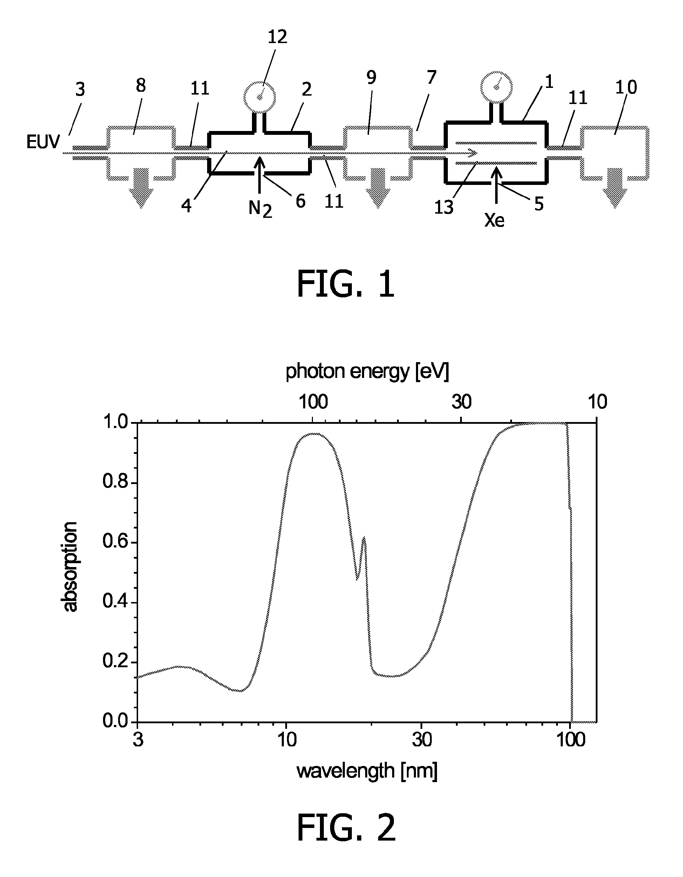

Such an energy sensor for EUV-radiation is described in US 2003/0178566 A1. This sensor comprises a detection chamber having a gas inlet for supply of a detection gas and a measuring unit for measuring shock waves which are induced by interaction of the radiation with the detection gas in said detection chamber. The energy of the shock wave which is dependent on the energy of the incident EUV-radiation is measured with acoustic transducers. As the gas absorption is independent of debris and no optical components are used a very long a lifetime of this sensor is claimed. The proposed sensor, however, is not specific for a limited bandwidth around 13.5 nm, i.e. the spectral range which should be controlled by the feedback loop described above. Figure 2 shows an example of the absorption of 500 Pa*cm xenon used as a detection gas in such a radiation energy sensor. It can be seen that xenon absorbs EUV-radiation well within the spectral range of interest, i.e. at 13.5 nm ± 2%, but also in the whole UV-region between 10 nm and 20 nm and significantly in the deep UV, especially between 50 nm and 100 nm. This means that the energy measured with such a sensor is a measure of the deep UV and EUV-radiation energy and not only of the EUV-radiation energy in the narrow spectral band required for a correctly working feedback loop.

An object of the present invention is to provide a radiation energy sensor, in particular for EUV-radiation and/or soft X-rays, which is insensitive to debris and has an improved spectral selectivity.

The object is achieved with the radiation energy sensor according to claim 1. Claim 8 relates to a method of operating such a sensor. Advantageous embodiments of the sensor and the method are subject of the sub claims or disclosed in the subsequent description.

The radiation energy sensor of the present invention, in particular for EUV-radiation and/or soft X-rays, comprises a detection chamber having a gas inlet for supply of a detection gas and a measuring unit for measuring effects which are caused by interaction of the radiation with the detection gas in said detection chamber and which are dependent on the energy of the radiation. The proposed energy sensor has a second chamber with a gas inlet for supply of a filtering gas. The second chamber is arranged between an entrance opening for the radiation and said detection chamber. Said second chamber is connected with said detection chamber via a passage allowing the straight pass of said radiation between the entrance opening and the detection chamber.

Due to this arrangement of chambers in the proposed sensor the radiation after entering through the entrance opening of the sensor passes the second chamber containing the filtering gas prior to the detection chamber for the measurement of radiation energy. By selection of an adequate filtering gas which is essentially transparent for the desired radiation to be measured but which absorbs interfering radiation which should not be measured, only the desired radiation enters in the detection chamber. This drastically improves the spectral response of the sensor and is in particular useful for monitoring the energy of EUV-radiation in an EUV irradiation apparatus. Since the additional filtering of the radiation as achieved without the use of sensitive optical components like multilayer mirrors or transmission filters the present radiation energy sensor is insensitive to debris.

In the radiation energy sensor of the present invention different measuring units, not limited to the physical measuring principles described below, can be used depending on the kind of effect to be measured. One possibility is to measure the fluorescence light emitted by the interaction of the radiation with the detection gas. The fluorescence light can be measured with one or several photodiodes which should be placed outside of the straight path of the radiation entering the present sensor. Since the fluorescence light is emitted in all directions the photodiode(s) can be arranged at an angle of 90° to said straight path. This has the advantage that debris entering with the radiation on said straight path will not be deposited on the photodiode(s). The photodiode(s) can also be mounted outside the chamber, i.e. behind a protecting optical window in the wall of the chamber. The measured intensity of the fluorescence light is a direct measure of the energy of the incident radiation.

Another possibility for measuring an effect caused by the interaction of the radiation with the detection gas is the use of one or several acoustic transducers, for example microphones, which measure the amplitude of shock waves generated due to said interaction. The shock waves are caused by the partial pressure of free electrons which are created by ionization of the atoms of the detection gas when absorbing said radiation. The measuring principle is the same as already disclosed in the aforesaid US 2003/0178566 A1.

The EUV energy measurement can also be improved by directly detecting the free electrons created by the interaction of the radiation with the detection gas. In this case the measuring unit comprises two opposing plate like electrodes, for example metal plates, within the detection chamber. The metal plates or plate like electrodes are arranged such in said detection chamber that the radiation passes between the two plates. The arrangement of said plates is preferably parallel to the straight pass of the radiation. A potential difference is applied to said electrodes. The positively charged electrode will collect the free electrons. This is measured with a suitable measuring instrument, e.g. an ampere meter. The quantum efficiency (QE, electrons/photon) of the sensor can be expressed as QE = χ * T_{fg} (1-T_{dg}), in which T_{fg} and T_{dg} represent the transmissions of the filtering gas and of the detection gas, respectively. The factor χ corrects for the fact that the absorption of a photon depending on its energy may produce a fast free electron, which can easily ionize another atom of the detection gas creating a second free electron. Therefore, χ will be equal to or larger than 1. When measuring for example EUV-radiation using xenon as detection gas the absorption of an EUV-photon produces a fast electron of approximately 90 eV which can easily ionize another xenon atom creating the second free electron. Therefore, in this case χ will be larger than 1. Its exact value also depends on the geometry of the detection chamber and the pressure of the detection gas.

In a preferred embodiment of the present radiation energy sensor at each side of the two chambers a differential pumping stage is installed, preferably consisting of a connecting chamber to attach a pump and small passages, preferably capillaries, for connecting said connection chambers to said second chamber, said detection chamber and said entrance opening. These pumping stages separate the second chamber from the detection chamber and from the light source. Moreover, they provide a clear definition of the distance over which the gases are absorbing radiation. The chambers and passages are arranged such that the straight pass of radiation from the entrance opening of the sensor to the detection chamber is allowed through said chambers and passages. With the differential pumping stages it is possible to use the present radiation sensor in a EUV irradiation unit requiring a very low gas pressure inside. With the differential pumping stages it is possible to maintain a higher pressure within the second chamber and the detection chamber without negatively influencing the pressure inside the volume of the irradiation unit. The arrangement of a connecting chamber between the second chamber and the detection chamber has the further advantage that the filtering gas does not reach the detection chamber and, therefore, cannot mix with the detection gas in the detection chamber.

The present radiation sensor has been described with two chambers, i.e. the second chamber and the detection chamber, and optionally with further connection chambers for attaching pumps to the sensor. Nevertheless it is also possible to provide even more chambers through which the radiation passes from the entrance opening to the detection chamber, for example a debris mitigation chamber for slowing down and stopping fast ions and slow atoms of debris. Such a chamber can be filled for example with 200 Pa*cm of argon (all pressure data in this patent application refer to a temperature of 300 K), in order to achieve the desired mitigation effect.

The detection gas obviously has to be selected such that the desired interaction between the radiation and the detection gas occurs. For measuring EUV-radiation an appropriate detection gas would be xenon. Due to the strong absorption of EUV-radiation in xenon gas the above described effects like the generation of fluorescence light or of free electrons are achieved, which are dependent on the energy of the incident EUV-radiation. When using the present radiation energy detector with radiation in other wavelength ranges other appropriate detection gases are selected. The same applies for the filtering gas which should be able to filter radiation in a wavelength range which normally would disturb the measurement of the desired radiation to be measured.

In the present description and claims the word "comprising" does not exclude other elements or steps as well as an "a" or "an" does not exclude a plurality. Also any reference signs in the claims shall not be construed as limiting the scope of these claims.

The present radiation energy sensor and the corresponding method of operation are also described in connection with the following drawings in some exemplary embodiments without limiting the scope of the claims. The figures show:
- Fig. 1: a schematic view of a first example of a radiation energy sensor according to the present invention;
- Fig. 2: a diagram showing the absorption of 500 Pa*cm xenon in a wavelength range between 3 and 100 nm;
- Fig. 3: a diagram showing the transmission of 1*10³ Pa*cm nitrogen compared with the transmission of the same xenon density;
- Fig. 4: a diagram showing the calculated quantum efficiency for a sensor according to the present invention using 500 Pa*cm xenon as detection gas and nitrogen as filtering gas;
- Fig. 5: a diagram showing a comparison of a typical spectrum of a tin based discharge source with the calculated spectral response of the present sensor when using 500 Pa*cm xenon and 2*10³ Pa*cm nitrogen; and
- Fig. 6: a schematic view of a further radiation energy sensor according to the present invention.

The following example refers to a radiation energy sensor for monitoring the energy of EUV-radiation in an EUV irradiation unit. An example of such a sensor is schematically depicted in figure 1. The sensor comprises two chambers 1, 2 filled with gas. The first chamber, the detection chamber 1, is filled with xenon gas for detection of the EUV-photons. The second chamber, the filter chamber 2, is filled with nitrogen to remove the deep UV part from the spectrum of the incident radiation. The EUV-radiation is typically produced from a plasma source emitting also radiation in the deep UV region. Filter chamber 2 and detection chamber 1 are connected via a passage 7. At each end of these chambers 1, 2 a differential pumping stage is installed consisting of a connecting chamber 8, 9, 10 to attach the necessary pumps and connection passages 11 which connect the connection chambers 8, 9, 10 with the entrance opening 3 for the EUV-radiation, with the filter chamber 2 and with the detection chamber 1. The arrangement of all chambers 1, 2, 8, 9, 10 and passages 11 is such that the EUV-radiation entering through the entrance opening 3 passes on a straight path 4 between the entrance opening 3 and the detection chamber 1 through all chambers and passages. The pumps attached to the connection chambers 8, 9, 10 are not directly shown in figure 1 but only indicated by thick arrows showing the pumping direction. The filter chamber 2 and the detection chamber 1 have inlets 5, 6 for gas supply of the filtering gas, in the present case nitrogen, and of the detection gas, in the present case xenon. Pressure gauges 12 are mounted on these two chambers 1, 2 in order to control the pressure of the gases in the chambers. The final connection chamber 10 on the right side of figure 1 also serves as a beam dump.

For 100 Pa (upstream) gas pressure a capillary 11 of 1 mm diameter and 5 mm length has a flow conductance of typically 10⁻²l/s. This means that 1 Pa*l/s is flowing into each connection chamber. This means that with a very moderate pumping rate of 10 l/s each connection chamber can be kept below 10⁻¹ Pa.

In the present example the effect of generation of free electrons is used to measure the energy of the EUV-radiation within the detection chamber. The free electrons are generated in the absorption process and are measured with two plate like electrodes 13 which are used to collect the charge. The two electrodes 13 are applied with a potential difference to this end.

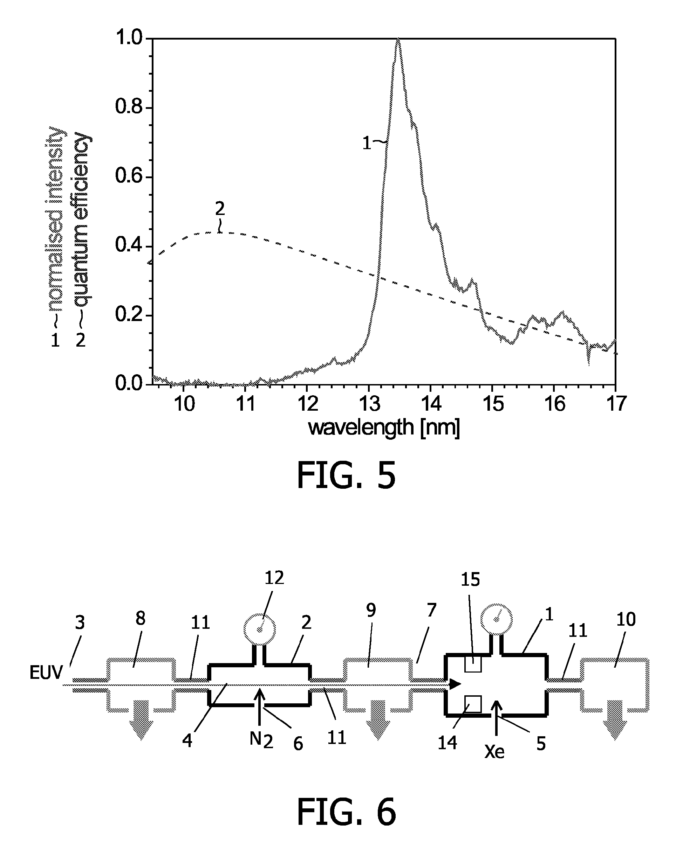

For 1.5 J pulse energy, a conversion energy of 2%/2% BW/2π sr and a spectral efficiency (inband power over total EUV power) of 20% the EUV lamp produces 0.15 J/2π sr EUV, which corresponds to roughly 10¹⁶ EUV photons (one photon has about 100 eV). A diaphragm with 0.5 mm diameter as an electrode at 250 mm distance from the EUV source collects a fraction of 5*10⁻⁷, i.e. 5*10⁹ photons / pulse. Assuming the sensor response of figure 5, which is described later, this results in 1.5*10⁹ electrons, i.e. a collected charge of 0.24 nC / pulse.

At high repetition rates the sensitivity of the sensor may change because not all of the charge produced by the previous pulse has been removed when the following pulse arrives. This can be avoided by choosing the radial dimension of the filter chamber 2 and of the detection chamber 1 small enough, i.e. a couple of mm. In this case the diffusion of the ions towards the walls where they recombine will be fast enough.

The present setup is not sensitive to debris. The fast ions and slow atoms will be stopped within 2*10³ Pa*cm nitrogen in the filter chamber 2. The droplets just fly through the sensor and will be collected in the beam dump. The droplets have a limited velocity and therefore they will arrive too late to have a significant influence on the charge collection. Nevertheless it is also possible to further extend the sensor with an extra differential pumping stage and an extra debris mitigation chamber which can be filled with at least 200 Pa*cm argon to stop the fast ions.

A similar setup of the present radiation energy sensor is depicted in figure 6. In this figure the only difference to the setup of figure 1 is the measuring unit which is not formed of electrodes. In the embodiment of figure 6 a photodiode 14 is shown which collects fluorescence light at an angle of 90° with respect to the straight radiation path 4 in the detection chamber 1. Instead of arranging the photodiode 14 inside the detection chamber, it is also possible to mount the photodiode 14 outside of the detection chamber. In this case, an optical window, e.g. of glass, is arranged in the wall of the detection chamber to allow the detection of the fluorescence light with the photodiode.

The intensity of the fluorescence light is a direct measure of the energy of the EUV radiation absorbed in the detection gas. In the same figure also a microphone 15 is shown which measures the shock wave amplitude produced by the absorption of the EUV radiation in the detection gas. Although for the purpose of illustration these too different measurement units, i.e. the photodiode 14 and the microphone 15, are shown in the same sensor in figure 6, a sensor normally only comprises one of these measuring units.

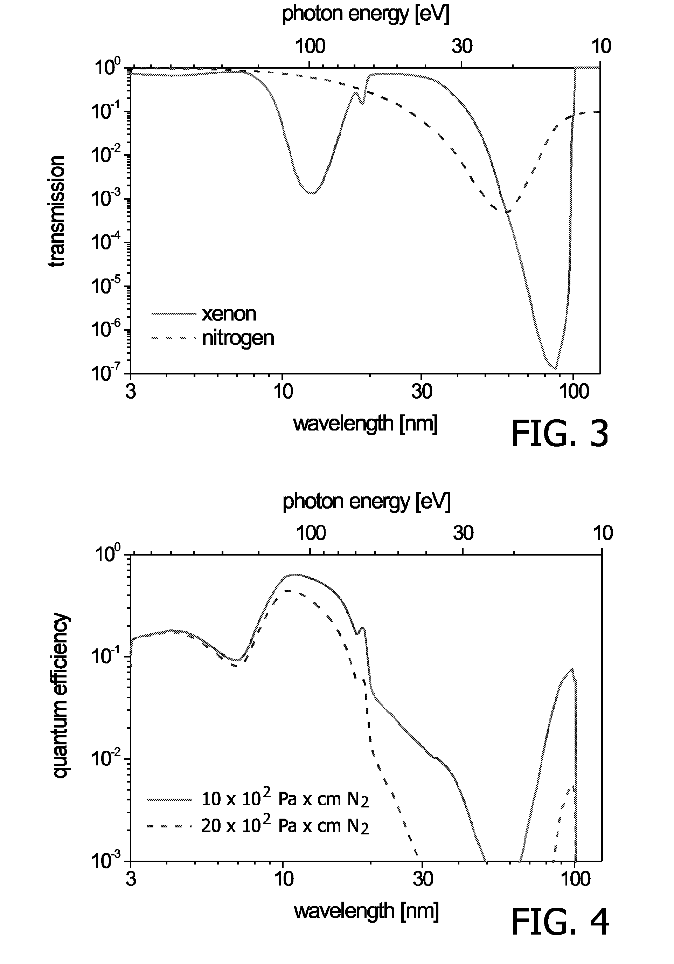

In order to operate the proposed radiation energy sensor for measuring the energy of EUV radiation it is advantageous to use xenon as a detection gas. Figure 2 shows the absorption of 500 Pa*cm xenon in the interesting wavelength range. It can be seen that xenon absorbs the EUV-radiation well in the spectral ranges of interest between 10 and 20 nm but also very good in the deep UV, especially between 50 and 100 nm. This absorption in the deep UV region, however, disturbs the measurement of EUV-radiation since the measured signal would not only be dependent on the EUV radiation but also on the deep UV radiation. With use of nitrogen as a filtering gas in the filter chamber 2 the spectral response of the sensor can be drastically improved. Figure 3 shows the transmission for 10³ Pa*cm nitrogen and xenon. It can be seen that both gases absorb well in the deep UV above 30 nm whereas only xenon absorbs in the EUV range between 10 and 20 nm. This means that the deep UV part of the radiation entering the energy sensor is absorbed in the filter chamber 2 and mainly the desired EUV radiation arrives at the detection chamber 1 and contributes to the measured signal.

Figure 4 shows a typical response of the proposed sensor with the two gases. In the figure the calculated quantum efficiency for a sensor containing 500 Pa*cm xenon and two different integrated densities of nitrogen filtering gas are shown. In the calculation the factor x is set to unity for case of simplicity. Due to the supply of nitrogen to the filter chamber 2 the sensor is insensitive for deep UV radiation. The improvement is roughly one order of magnitude for 10³ Pa*cm nitrogen between 90 and 100 nm and for the rest of the spectrum even more.
Figure 5 shows the spectrum of a tin based EUV-radiation source as well as the calculated spectral response of the proposed sensor with 500 Pa*cm xenon as detection gas and 2*10³ Pa*cm nitrogen as filtering gas. The quantum efficiency has its maximum of almost 0.5 at 10.5 nm. At this wavelength, however, no radiation is emitted by an EUV lamp using tin as fuel. The quantum efficiency decreases for longer wavelengths so that the sensor is slightly more sensitive for the so called unresolved transition array at 13.5 nm than for longer EUV wavelengths. If the shape of the EUV spectrum remains more or less constant from pulse to pulse, the proposed sensor is very suitable for pulse-to-pulse energy monitoring of an EUV-radiation source.

### LIST OF REFERENCE SIGNS

- 1: detection chamber
- 2: filter chamber
- 3: entrance opening
- 5: inlet for detection gas
- 6: inlet for filtering gas
- 7: passage connecting filter and detection chamber
- 8: connection chamber
- 9: connection chamber
- 10: connection chamber
- 11: passage
- 12: pressure gauge
- 13: plate like electrodes
- 14: photodiode
- 15: microphone

## Claims

1. Radiation energy sensor, in particular for EUV radiation and/or soft X-rays, comprising a detection chamber (1) having a gas inlet (5) for supply of a detection gas and a measuring unit (13, 14, 15) for measuring effects which are caused by interaction of the radiation with the detection gas in said detection chamber (1) and which are dependent on the energy of the radiation, **characterized in that** a second chamber (2) having a gas inlet (6) for supply of a filtering gas is arranged between an entrance opening (3) for the radiation and said detection chamber (1), said second chamber (2) being connected with said detection chamber (1) via a passage (7, 9, 11) allowing the straight pass of said radiation between the entrance opening (3) and the detection chamber (1).

2. Radiation energy sensor according to claim 1, **characterized in that** a connection chamber (9) for attaching a pump is arranged between the second chamber (2) and the detection chamber (1), wherein said connection chamber (9) is connected via straight passages (11) to said second chamber (2) and to said detection chamber (1), said passages (11) allowing said straight pass of radiation between the entrance opening (3) and the detection chamber (1) as well as a differential pumping of the detection gas and of the filtering gas.

3. Radiation energy sensor according to claim 1, **characterized in that** connection chambers (8, 9) for attaching pumps are arranged on both sides of the second chamber (2) with respect to said straight pass of radiation, wherein a first of said connection chambers (8, 9) is connected via straight passages (11) to said second chamber (2) and to said detection chamber (1) and a second of said connection chambers (8, 9) is connected via straight passages (11) to said second chamber (2) and to said entrance opening (3), said passages (11) allowing said straight pass of radiation between the entrance opening (3) and the detection chamber (1) as well as a differential pumping of the detection gas and of the filtering gas.

4. Radiation energy sensor according to claim 1 or 2, **characterized in that** said measuring (13, 14, 15) unit comprises at least one photodiode (14) for measuring an intensity of fluorescence light emitted by the interaction of the radiation with the detection gas.

5. Radiation energy sensor according to claim 1 or 2, **characterized in that** said measuring unit (13, 14, 15) comprises at least one pair of plate like electrodes (13), said electrodes (13) being connected to a voltage source for applying a potential difference between the electrodes (13) and to a measuring instrument for measurement of an amount of free electrons collected by one of said electrodes (13) and generated by the interaction of the radiation with the detection gas, wherein said electrodes (13) are arranged to allow said straight pass of the radiation between the electrodes (13).

6. Radiation energy sensor according to claim 1 or 2, **characterized in that** said measuring unit (13, 14, 15) comprises at least one acoustic transducer (15) for measuring an amplitude of acoustic shockwaves created by the interaction of the radiation with the detection gas.

7. Radiation energy sensor according to claim 2 or 3, **characterized in that** said passages (11) are formed of capillaries.

8. Method of operating a radiation energy sensor according to claim 1, wherein a detection gas absorbing radiation of a to be measured wavelength range is supplied to said detection chamber (1) and a filtering gas essentially transparent for the radiation of the to be measured wavelength range and absorbing interfering radiation is supplied to said second chamber (2).

9. Method according to claim 8, wherein for measuring EUV-radiation a filtering gas absorbing UV radiation is supplied as filtering gas.

10. The use of a radiation sensor according to claim 1 for monitoring the energy of EUV-radiation in an EUV-irradiation unit on a pulse to pulse basis.

11. The use according to claim 10, wherein the energy of EUV-radiation of each pulse is measured with said radiation sensor and used in a feed back loop to control a discharge energy.
